# FASCICULE DE BREVET EUROPEEN

(11) **EP 4 662 498 B1**
(45) Date de publication et mention de la délivrance du brevet: **21.10.2026**
(21) Numéro de dépôt: 24705212.9
(22) Date de dépôt: 31.01.2024
(51) Int. Cl.: G01R 31/68

(54) **PROCÉDÉ D'ÉVALUATION DE LA FIABILITÉ D'UNE CONNEXION ENTRE DES CONTACTS ÉLECTRIQUES**
VERFAHREN ZUR BEWERTUNG DER ZUVERLÄSSIGKEIT EINER VERBINDUNG ZWISCHEN ELEKTRISCHEN KONTAKTEN
METHOD FOR EVALUATING THE RELIABILITY OF A CONNECTION BETWEEN ELECTRICAL CONTACTS

(30) Priorité: 06.02.2023 FR 2301103
(43) Date de publication de la demande: 17.12.2025
(73) Titulaire: Safran Electrical & Power, 31702 Blagnac (FR)
(72) Inventeur: TCHAAOUAOU, Ismaïl, 77550 MOISSY-CRAMAYEL (FR); FARDEL, Yves, 77550 MOISSY-CRAMAYEL (FR)
(74) Mandataire: Santarelli
(86) Numéro de dépôt international: PCT/FR2024/050130
(87) Numéro de publication internationale: WO 2024/165808

(56) Documents cités:
- CN-A- 113 297 751
- CN-A- 114 646 559
- US-A- 5 028 492
- XU L ET AL: "Fretting wear and reliability assessment of gold-plated electrical connectors", MICROELECTRONICS RELIABILITY : AN INTERNAT. JOURNAL & WORLD ABSTRACTING SERVICE, ELSEVIER SCIENCE LTD, GB, vol. 100, 1 September 2019 (2019-09-01), XP085897849, ISSN: 0026-2714, [retrieved on 20190923], DOI: 10.1016/J.MICROREL.2019.06.040
- PRADEEP LALL ET AL: "Leading indicators for prognostic health management of electrical connectors subjected to random vibration", THERMAL AND THERMOMECHANICAL PHENOMENA IN ELECTRONIC SYSTEMS (ITHERM), 2012 13TH IEEE INTERSOCIETY CONFERENCE ON, IEEE, 30 May 2012 (2012-05-30), pages 632 - 638, XP032453337, ISBN: 978-1-4244-9533-7, DOI: 10.1109/ITHERM.2012.6231488
- LIU XIN-LONG ET AL: "Influence of Humidity on Endurance of Electrical Contact during Fretting Wear", JOURNAL OF MATERIALS ENGINEERING AND PERFORMANCE, ASM INTERNATIONAL, MATERIALS PARK, OH, US, vol. 31, no. 2, 13 October 2021 (2021-10-13), pages 933 - 943, XP037680522, ISSN: 1059-9495, [retrieved on 20211013], DOI: 10.1007/S11665-021-06280-4

## Description

### DOMAINE TECHNIQUE

L'invention concerne le domaine de l'évaluation de la durée de vie, et donc de la fiabilité, de connexions électriques entre des connecteurs soumis à des contraintes mécaniques, notamment des contraintes vibratoires. L'invention s'applique avantageusement au domaine de la connectique électrique utilisée dans des véhicules de transport, notamment aérien, automobile ou ferroviaire.

### ÉTAT DE LA TECHNIQUE ANTERIEURE

Le « fretting » est un mouvement relatif oscillatoire de faible amplitude (de quelques µm à quelques dizaines de µm) pouvant être observé à l'interface de deux pièces en contact quasi-statique l'une avec l'autre, lorsque ces pièces sont soumises à des contraintes vibratoires et/ou des déplacements relatifs. Il s'agit dans la majorité des cas d'un mouvement tangentiel des pièces l'une contre l'autre, et est généralement une conséquence des sollicitations vibratoires que le système comprenant ces pièces rencontre. Par exemple, dans le cas des systèmes embarqués dans des véhicules de transport, notamment des aéronefs, ces déplacements sont provoqués par les vibrations générées par les moteurs des véhicules.

Le fretting est un phénomène observé dans de nombreux systèmes (électriques et/ou mécaniques), et constitue l'une des causes principales d'avarie des pièces en contact. Il provoque une trace d'usure localisée de faibles dimensions, généralement proportionnelles à la surface de contact des pièces et à l'amplitude du débattement engendré entre les pièces.

Un connecteur électrique est composé d'un boîtier doté d'un ou plusieurs logements dans lesquels se trouvent un ou plusieurs contacts électriques. Les connecteurs servent notamment à la connexion de deux harnais (faisceaux composés chacun d'un ou plusieurs câbles électriques entourés par une gaine de protection) entre eux, ou d'un harnais avec un équipement électrique. Lorsque deux connecteurs sont couplés l'un à l'autre, leurs contacts électriques réalisent la connexion électrique entre eux. Ces contacts électriques sont généralement de type mâle/femelle (ou « pin/socket » en anglais), l'enfichage du contact mâle dans le contact femelle assurant la connexion électrique entre eux.

La performance électrique d'une connexion entre deux contacts électriques est généralement mesurée par la résistance électrique de contact entre ces deux contacts électriques. Plus cette résistance électrique est faible, meilleure est le contact. Cette résistance électrique de contact dépend de plusieurs facteurs tels que la surface et la force de contact, la résistivité des matériaux des contacts électriques, la température, etc.

Les contacts électriques sont généralement en cuivre ou alliage de cuivre, et disposent souvent d'un revêtement permettant de garantir une protection vis-à-vis de l'environnement extérieur dans le but de protéger le cuivre ou l'alliage de cuivre contre la corrosion tout en assurant de bonnes performances électriques des contacts. Dans le cas des contacts électriques de forte puissance, ces revêtements sont généralement des dorures ou des argentures.

Les connecteurs peuvent être installés dans des environnements à fortes contraintes vibratoires et ces vibrations se propagent alors jusqu'à l'interface entre les contacts électriques. Un mouvement relatif peut alors être observé entre eux (correspondant au fretting), et la répétition de ce mouvement tangentiel à la surface de contact peut provoquer une usure de contact. Le fretting provoque la dégradation des revêtements protecteurs des contacts électriques, qui sont alors exposés à l'environnement extérieur. Le substrat cuivreux des contacts électriques subit alors une corrosion et les débris de cette usure s'oxydent, ce qui détériore fortement la résistance électrique de contact et la durée de vie des contacts électriques. L'augmentation de la résistance de contact entraine un échauffement localisé du contact, ce qui a pour effet d'augmenter encore plus sa résistance. Un phénomène d'emballement thermique peut alors être observé, menant dans le pire des cas à un départ de feu.

Dans le cas d'applications liées à la forte puissance, les forts courants électriques peuvent générer des échauffements plus importants que ceux observés au niveau des contacts de faible puissance. Ces échauffements provoquent des dilatations des différents matériaux constituant le connecteur, ce qui autorise de plus grands mouvements relatifs des contacts électriques. Cet échauffement a également des conséquences sur la dégradation des performances électriques du contact, puisque le phénomène d'oxydation s'accélère avec la température. Dans un contexte de forte puissance, le risque d'usure par fretting ne permet donc plus de garantir la fiabilité des connecteurs et peut devenir une cause majeure d'avarie s'il n'est pas pris en compte.

Le fretting est impacté par plusieurs facteurs pouvant modifier le comportement et l'usure du contact, tels que le choix des matériaux, l'épaisseur des revêtements, la température, l'humidité, etc. Le paramètre le plus impactant de l'usure par fretting d'un contact électrique est l'amplitude de débattement de ce contact électrique lorsque celui-ci est soumis à une contrainte. Quel que soit le type de revêtement utilisé pour la protection des contacts électriques, l'amplitude de débattement a une influence majeure sur l'usure par fretting et donc sur la durée de vie des contacts.

Il existe deux principaux modes de glissements lorsque deux contacts électriques connectés l'un avec l'autre sont soumis à des contraintes de fretting :
- le glissement partiel : il s'agit d'un glissement observé lorsque l'amplitude de débattement est faible et inférieure à une amplitude seuil appelée « amplitude de transition ». Dans ce cas, le contact est caractérisé par une zone dite « collée » se trouvant au centre de l'interface entre les deux contacts électriques et entourée d'une zone dite « de glissement » se trouvant en périphérie de cette interface. Au niveau de la zone « collée », aucun glissement n'est observé et donc le contact ne subit pas de dégradation. Dans ce cas, le contact métal/métal entre les contacts électriques est maintenu dans le temps, et la durée de vie du contact peut être considérée comme infinie. En revanche, plus l'amplitude de débattement est grande, plus la surface de la zone collée est petite, jusqu'à être nulle lorsque l'amplitude de débattement est supérieure ou égale à l'amplitude de transition,
- le glissement total : un tel glissement se produit lorsque l'amplitude de débattement dépasse l'amplitude de transition. Le glissement est alors généralisé à l'ensemble de la surface de contact et la détérioration conduit à l'augmentation de la résistance jusqu'à la défaillance électrique du contact.

L'évolution de l'endurance d'une connexion entre deux contacts électriques, c'est-à-dire le nombre de cycles de fretting nécessaire pour aboutir à la défaillance de cette connexion, en fonction de l'amplitude de débattement, peut être modélisée par une loi de puissance décroissante. Le critère de fin de vie d'une connexion est basé sur une valeur seuil de la résistance de contact à ne pas dépasser. Pour un matériau donné, et pour des conditions de connexion données, il existe une valeur seuil de l'amplitude de débattement au-dessus de laquelle l'endurance du contact électrique diminue fortement.

Ainsi, l'amplitude du débattement que subissent deux contacts électriques connectés l'un à l'autre est un facteur déterminant sur l'endurance, ou la durée de vie, de la connexion de ces deux contacts électriques, c'est-à-dire sur le nombre de cycles de fretting nécessaires pour atteindre une valeur seuil de résistance de contact considérée comme une avarie. Plus l'amplitude de débattement est faible, plus la durée de vie du contact est grande. Cette amplitude de débattement est spécifique à chaque connexion, car elle dépend de la conception des éléments de cette connexion qui est un assemblage de solutions techniques basées sur des paramètres tels que les matériaux mis en œuvre, la force de contact appliquée, la surface de contact, etc. Elle dépend également de paramètres environnementaux tels que la température.

Pour calculer le risque d'usure par fretting d'un connecteur donné, il est nécessaire de connaitre l'amplitude de déplacement que subira ce connecteur en service (par exemple en vol dans le cas de connecteurs utilisés dans un aéronef). Elle dépend en outre de la conception du connecteur et de la « liberté » de déplacement du ou des contacts électriques logés dans le connecteur. Les éléments utilisés pour évaluer cette amplitude sont : les tolérances de fabrication de chacune des pièces constituant le connecteur, les jeux d'assemblage, les déformations élastiques des pièces soumises aux contraintes vibratoires, les dilatations des matériaux en fonction de la température d'utilisation. Il est donc très difficile d'estimer cette amplitude et de pouvoir garantir la fiabilité du contact, et donc d'évaluer le risque d'usure par fretting au sein d'un connecteur donné.

Il existe différentes méthodes pour évaluer la fiabilité d'un connecteur soumis à des contraintes vibratoires.

Une première méthode consiste à réaliser des essais vibratoires selon la norme d'essais NF EN2591 : il s'agit des essais de qualification classiques d'un connecteur électrique utilisé dans le domaine de l'aéronautique. Ces essais consistent à appliquer une sollicitation vibratoire selon 3 axes (6 directions) pendant une durée définie (généralement 8 heures). De nombreux contrôles sont ensuite effectués, et garantir que les performances fonctionnelles du connecteur ne seront pas détériorées. Ces contrôles sont généralement des mesures des forces d'accouplement/désaccouplement, des forces d'enfichage/désenfichage du ou des contacts électriques du connecteur, et des mesures de résistance du ou des contacts électriques. Ces essais vibratoires permettent de vérifier que le connecteur ne subit pas d'endommagement (notamment au niveau du boitier du connecteur) et que la connexion est maintenue lorsque le connecteur subit des vibrations.

Par contre, il ne s'agit pas d'essais suffisamment longs pour estimer la tenue dans le temps du connecteur. De plus, avec cette première méthode, les essais vibratoires mettent en vibration l'ensemble du connecteur, mais ne garantissent pas qu'un mouvement de fretting se produit sur le ou les contacts électriques du connecteur. En effet, les contacts électriques peuvent se déplacer en déplacement relatif (opposition de phase) ce qui provoque du fretting, mais peuvent également se déplacer ensemble (en phase), auquel cas aucun mouvement de fretting ne se produit. Ceci est dû au fait que le connecteur est composé de pièces de différentes raideurs pouvant amortir les déplacements, ce qui a pour conséquence que le ou les contacts électriques à l'intérieur du connecteur ne se déplacent pas de la même manière que le connecteur en vibration.

Le connecteur ne réagit pas non plus de la même manière en fonction de la température et des contraintes vibratoires subies, ce qui rend difficile de savoir si du fretting se produit pendant l'essai vibratoire, et si oui, il n'est pas possible de connaitre l'amplitude de débattement entre les contacts électriques connectés. En effet, cette amplitude de débattement vue par les contacts électriques dépend de nombreux facteurs, tels que les jeux d'assemblage des pièces constituant le connecteur, les dilatations des pièces dues aux variations de températures, et l'élasticité des matériaux soumis aux contraintes vibratoires.

Une autre méthode permettant d'évaluer le comportement d'un connecteur soumis à des contraintes vibratoires est de le soumettre à des essais vibratoires sévères : il s'agit d'essais pour lesquels le niveau vibratoire et/ou la durée ont été augmentés dans le but d'augmenter les contraintes vibratoires subies par le connecteur. Ainsi, on augmente la possibilité/probabilité de créer du fretting au niveau du contact. En revanche, pour les mêmes raisons que dans la méthode précédente, ce type d'essai ne garantit pas l'apparition de fretting et ne permet pas de connaitre la sévérité de celui-ci (notamment l'amplitude de débattement). Le document CN114646559A divulgue également un exemple de procédé d'évaluation de la durée de vie d'une connexion électrique.

Lors du développement d'un connecteur électrique de forte puissance destiné à être embarqué dans un aéronef, plusieurs phénomènes physiques sont pris en compte, et le dimensionnement du connecteur qui en résulte doit permettre de garantir sa fiabilité tout au long de la durée de vie de l'aéronef. Le fretting étant également un phénomène dimensionnant pour le connecteur (car source d'avaries sévères), il est important de l'évaluer afin de le prendre en compte lors du développement du connecteur.

Ce besoin d'évaluer la durée de vie d'une connexion électrique entre deux connecteurs en tenant compte du risque d'usure par fretting des contacts électriques de ces connecteurs se retrouve également dans des domaines autres que celui de l'aéronautique, et plus généralement dans tout le domaine de la connectique électrique.

### EXPOSÉ DE L'INVENTION

Un but de la présente invention est de proposer un procédé d'évaluation de la durée de vie d'une connexion électrique entre au moins deux connecteurs chacun doté d'au moins un contact électrique, tenant compte de l'usure de contact due au fretting.

Pour cela, l'invention propose un procédé d'évaluation de la durée de vie d'une connexion électrique entre au moins deux connecteurs comprenant chacun au moins un contact électrique logé dans un boîtier, les boîtiers des deux connecteurs étant configurés pour être couplés mécaniquement l'un à l'autre, comprenant les étapes suivantes :
- mesure de l'évolution de la résistance électrique de contact entre les contacts électriques seuls, sans la présence d'autre élément des connecteurs, en fonction d'un nombre de déplacements des contacts électriques l'un contre l'autre et pour plusieurs valeurs d'amplitude de déplacement des contacts électriques l'un contre l'autre ;
- détermination, à partir des mesures de l'évolution de la résistance électrique de contact entre les contacts électriques, d'une fonction définissant un nombre de déplacements maximal au-delà duquel la résistance électrique de contact entre les contacts électriques dépasse une valeur maximale prédéfinie représentative d'un état dégradé de la connexion, en fonction de l'amplitude de déplacement ;
- mesure d'amplitudes de déplacement, au niveau de chacun des logements des boîtiers des connecteurs dans lesquels les contacts électriques sont destinés à être disposés, en soumettant les boîtiers à des sollicitations mécaniques d'amplitude et de fréquence de valeurs différentes ;
- détermination, à partir des mesures d'amplitudes de déplacement, de fonctions de transfert dynamique des boîtiers définissant l'amplitude de déplacement des contacts électriques en fonction de l'amplitude et de la fréquence des sollicitations mécaniques appliquées aux boîtiers ;
- détermination, pour des valeurs données d'amplitude et de fréquence de sollicitations mécaniques appliquées aux connecteurs, de la durée de vie de la connexion entre les connecteurs correspondant au nombre de déplacements maximal au-delà duquel la résistance électrique de contact entre les contacts électriques dépasse la valeur maximale prédéfinie représentative d'un état dégradé de la connexion, ce nombre de déplacements maximal étant déterminé à partir de la fonction définissant le nombre de déplacements maximal au-delà duquel la résistance électrique de contact entre les contacts électriques dépasse la valeur maximale prédéfinie représentative d'un état dégradé de la connexion en fonction de l'amplitude de déplacement, pour une amplitude de déplacement des contacts électriques l'un contre l'autre dont la valeur est déterminée par les fonctions de transfert dynamique des connecteurs pour les valeurs données d'amplitude et de fréquence des sollicitations mécaniques appliquées aux connecteurs.

La mesure de l'évolution de la résistance électrique de contact entre les premier et deuxième contacts électriques seuls mise en œuvre dans ce procédé correspond à une évaluation de l'endurance des contacts électriques seuls, notamment sans boîtier de connecteur, lorsqu'ils sont soumis à du fretting. Cette mesure permet de connaitre l'endurance de la connexion électrique formée entre les contacts électriques en fonction de l'amplitude de débattement et des conditions de fretting auxquelles les contacts électriques sont soumis.

Au cours du procédé, une détermination des fonctions de transfert dynamique des boîtiers vers les contacts électriques est également mise en œuvre par une méthode d'analyse modale expérimentale appliquée sur les connecteurs. Ainsi, il est possible de déterminer l'amplitude de déplacement des contacts électriques lorsque les connecteurs sont soumis à des vibrations extérieures.

Enfin, une comparaison de ces résultats est mise en œuvre pour conclure sur la fiabilité qualitative de la connexion en environnement vibratoire. En comparant l'amplitude de déplacement des contacts électriques dans les boîtiers avec la courbe d'endurance à cette même amplitude, il est possible de déterminer l'évolution dans le temps de la résistance électrique de contact entre les contacts électriques lorsqu'ils sont logés dans les connecteurs, pour des sollicitations mécaniques données, et donc déterminer la durée de vie de la connexion formée entre les connecteurs.

Avec ce procédé, il devient possible de savoir, en fonction des contraintes vibratoires subies par les connecteurs, si les contacts électriques de ces connecteurs subissent ou non du fretting. Il est donc possible d'évaluer la durée de vie de cette connexion en fonction des contraintes vibratoires subies, et donc par exemple en fonction de la zone d'installation des connecteurs dans un véhicule de transport tel qu'un aéronef.

A partir des résultats obtenus, il est possible de déterminer si un éventuel redimensionnement des contacts électriques (épaisseurs de revêtement, pression de contact, etc..) et/ou des pièces constituant les connecteurs (choix des matériaux vis-à-vis des dilatations, jeux d'assemblage, etc...) est judicieux.

Le procédé proposé permet de réellement prendre en compte le phénomène de fretting en le provoquant volontairement, de manière contrôlée, lors des essais d'endurance sur les contacts électriques, contrairement aux solutions de l'art antérieur basées sur des essais vibratoires au cours desquels du fretting peut ne pas se produire.

La détermination de l'endurance au fretting des connecteurs et des fonctions de transfert dynamique des connecteurs permet de déterminer au final la fiabilité de la connexion et ses limites d'utilisation (notamment les zones d'installation possibles de celle-ci). Cette évaluation de la durée de vie de la connexion peut permettre d'identifier des axes d'amélioration de la conception des contacts et/ou des connecteurs si la durée de vie déterminée n'est pas satisfaisante.

De manière avantageuse, le procédé peut être tel que :
- l'évolution de la résistance électrique de contact entre les contacts électriques seuls soit mesurée pour plusieurs valeurs de fréquence des déplacements subis par les contacts électriques lors de ces mesures, et la fonction définissant le nombre de déplacements maximal au-delà duquel la résistance électrique de contact entre les contacts électriques dépasse la valeur maximale prédéfinie représentative d'un état dégradé de la connexion en fonction de l'amplitude de déplacement soit déterminée pour ces différentes valeurs de fréquence des déplacements subis par les contacts électriques, et
- une fréquence de déplacement des logements des boîtiers soit également mesurée lorsque les boîtiers sont soumis aux sollicitations mécaniques d'amplitude et de fréquence de valeurs différentes, et les fonctions de transfert dynamique des boîtiers soient déterminées telles qu'elles définissent également des valeurs de fréquence de déplacement des contacts électriques en fonction des valeurs d'amplitude et de fréquence des sollicitations mécaniques, et
- le nombre de déplacements maximal au-delà duquel la résistance électrique de contact entre les contacts électriques dépasse la valeur maximale prédéfinie représentative d'un état dégradé de la connexion soit déterminé également pour une fréquence de déplacement des contacts électriques l'un contre l'autre dont la valeur est déterminée par les fonctions de transfert dynamique des boîtiers pour les valeurs données de l'amplitude et de la fréquence des sollicitations mécaniques.

Dans la configuration ci-dessus, la fréquence avec laquelle les contacts électriques subissent le fretting est également prise en compte dans l'évaluation de la durée de vie de la connexion, améliorant ainsi la précision dans cette évaluation.

De manière avantageuse, le procédé peut être tel que :
- les mesures de l'évolution de la résistance électrique de contact entre les contacts électriques seuls et des amplitudes de déplacement des logements des boîtiers soient chacune réalisées dans différentes conditions environnementales données pour lesquelles les valeurs de température et/ou d'humidité relative et/ou de pression diffèrent les unes des autres, et
- la fonction définissant le nombre de déplacements maximal au-delà duquel la résistance électrique de contact entre les contacts électriques dépasse la valeur maximale prédéfinie représentative d'un état dégradé de la connexion en fonction de l'amplitude de déplacement et les fonctions de transfert dynamique des boîtiers sont déterminées pour chacune des différentes conditions environnementales, et
- la durée de vie de la connexion entre les connecteurs est déterminée à partir de la fonction définissant le nombre de déplacements maximal au-delà duquel la résistance électrique de contact entre les contacts électriques dépasse la valeur maximale prédéfinie représentative d'un état dégradé de la connexion en fonction de l'amplitude de déplacement et des fonctions de transfert dynamique des boîtiers obtenues dans des conditions environnementales données identiques.

Dans la configuration ci-dessus, la température ambiante et/ou l'humidité relative et/ou la pression de l'environnement dans lequel se trouvent les connecteurs sont prises en compte dans l'évaluation de la durée de vie de la connexion, améliorant ainsi la précision dans cette évaluation.

Dans une configuration particulière, le procédé peut comporter en outre les étapes de :
- à partir des mesures de l'évolution de la résistance électrique de contact entre les contacts électriques seuls, détermination d'une valeur d'amplitude de déplacement des contacts électriques l'un contre l'autre pour laquelle la résistance électrique de contact entre les contacts électriques reste inférieure à une valeur prédéfinie représentative d'un début de dégradation de la connexion, et
- détermination, pour les valeurs données d'amplitude et de fréquence des sollicitations mécaniques appliquées aux connecteurs, d'une absence ou non de dégradation de la connexion entre les connecteurs en comparant la valeur d'amplitude de déplacement des contacts électriques l'un contre l'autre pour laquelle la résistance électrique de contact entre les contacts électriques reste inférieure à la valeur prédéfinie représentative d'un début de dégradation de la connexion avec la valeur d'amplitude de déplacement des contacts électriques l'un contre l'autre déterminée par les fonctions de transfert dynamique des boîtiers pour les valeurs données d'amplitude et de fréquence des sollicitations mécaniques appliquées aux connecteurs.

Dans la configuration particulière ci-dessus, le procédé permet de déterminer si, dans des conditions de fonctionnement données, la connexion est affectée ou non par du fretting.

De manière avantageuse, le procédé peut être tel que :
- les amplitudes de déplacement des logements des boîtiers soient mesurées par des accéléromètres et/ou des capteurs de vibration, et
- les sollicitations mécaniques auxquelles sont soumis les boîtiers soient appliquées par au moins un marteau d'impact doté d'une tête couplée à un capteur de force configuré pour mesurer l'amplitude et la fréquence des sollicitations mécaniques appliquées, ou par un pot vibrant, et
- les accéléromètres et/ou les capteurs de vibration, et le capteur de force ou le pot vibrant, soient couplés électriquement à au moins un analyseur de spectre déterminant les fonctions de transfert dynamique des boîtiers.

L'un des contacts électriques peut correspondre à un contact électrique mâle, et l'autre des contacts électriques peut correspondre à un contact électrique femelle.

Les valeurs différentes d'amplitude et de fréquence des sollicitations mécaniques peuvent être représentatives de différents emplacements dans un véhicule de transport. Dans ce cas, le véhicule de transport peut être un aéronef.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un exemple de réalisation de connecteurs dont la durée de vie de la connexion l'un avec l'autre est évaluée par le procédé, objet de l'invention ;
- la figure 2 représente schématiquement les étapes d'un procédé d'évaluation de la durée de vie d'une connexion électrique, objet de la présente invention ;
- la figure 3 représente schématiquement un exemple de fonction définissant un nombre de déplacements maximal au-delà duquel la résistance électrique de contact entre les contacts électriques dépasse une valeur maximale prédéfinie représentative d'un état dégradé de la connexion, en fonction de l'amplitude de déplacement, déterminée au cours d'un procédé d'évaluation de la durée de vie d'une connexion électrique, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSE DETAILLE DE MODES DE REALISATION PARTICULIERS

Un procédé d'évaluation de la durée de vie d'une connexion électrique entre au moins deux connecteurs 100, 102 configurés pour être couplés mécaniquement l'un à l'autre est décrit ci-dessous.

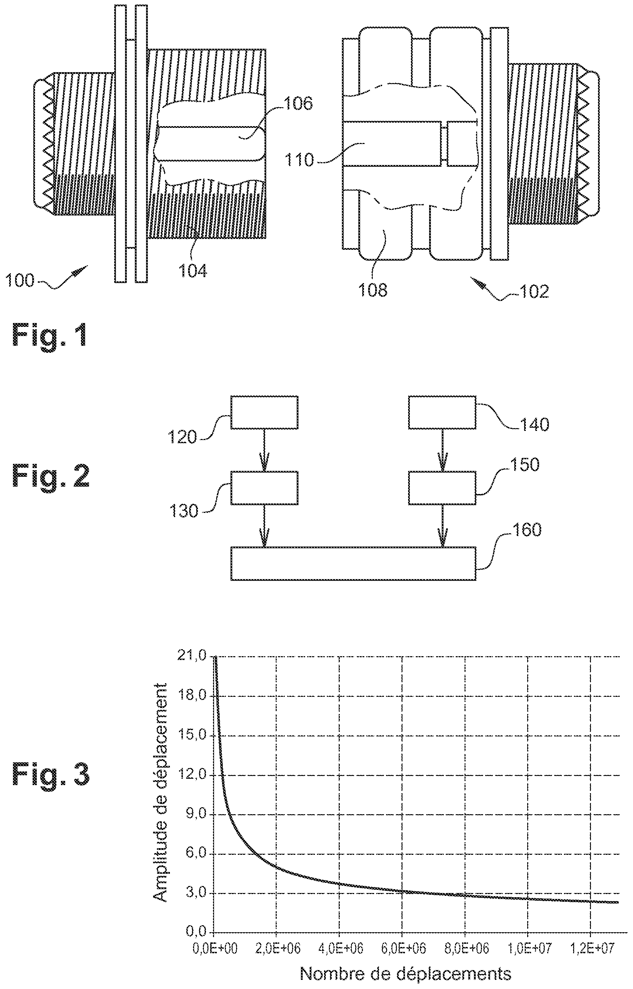

Un exemple de réalisation des deux connecteurs 100, 102 est visible sur la figure 1.

Le connecteur 100, appelé premier connecteur 100, comporte un premier boîtier 104 dans lequel est logé au moins un premier contact électrique 106. Dans l'exemple de réalisation représenté sur la figure 1, le premier connecteur 100 comporte un premier contact électrique 106 de type mâle. Le connecteur 102, appelé deuxième connecteur 102, comporte un deuxième boîtier 108 configuré pour être couplé mécaniquement au premier boîtier 104 et dans lequel est logé au moins un deuxième contact électrique 110. Dans l'exemple de réalisation représenté sur la figure 1, le deuxième connecteur 102 comporte un deuxième contact électrique 110 de type femelle et configuré pour être connecté électriquement au premier contact électrique 106.

Les étapes du procédé d'évaluation de la durée de vie de la connexion électrique entre les connecteurs 100, 102 lorsqu'ils sont couplés mécaniquement l'un à l'autre sont décrites ci-dessous et schématisées sur la figure 2.

Une étape 120 d'évaluation de l'endurance des contacts électriques 106, 110 est mise en œuvre. Cette étape 120 comporte une mesure de l'évolution de la résistance électrique de contact entre les contacts électriques 106, 110 seuls, sans la présence d'autre élément des connecteurs 100, 102 (en particulier sans les boîtiers 104, 108), en fonction d'un nombre de déplacements des contacts électriques 106, 110 l'un contre l'autre et pour plusieurs valeurs d'amplitude de déplacement.

Au cours de ces mesures, les contacts électriques 106, 110 sont soumis à du fretting en les déplaçant, par exemple longitudinalement, l'un contre l'autre, de préférence en déplaçant le premier contact électrique 106 lorsque celui-ci correspond à un contact électrique mâle et maintenant en position fixe le deuxième contact électrique 110 lorsque celui-ci correspond à un contact électrique femelle.

Ces mesures sont réalisées pour différentes valeurs d'amplitude de déplacement des contacts électriques 106, 110 l'un contre l'autre, et par exemple à l'aide d'un milliohmmètre.

Pour chacune des valeurs d'amplitude de déplacement choisies, l'évolution de la résistance électrique de contact entre les contacts électriques 106, 110 seuls est mesurée jusqu'à ce que la valeur de résistance électrique de contact mesurée dépasse une valeur maximale prédéfinie qui dépend des spécifications des connecteurs 100, 102 et qui est représentative d'un état dégradé de la connexion électrique entre les contacts électriques 106, 110, ou bien jusqu'à ce qu'un nombre de déplacements des contacts électriques 106, 110 l'un contre l'autre réalisés dépasse une valeur maximale, par exemple de l'ordre de 10 millions de cycles, permettant de considérer que les contacts électriques 106, 110 ne sont pas dégradés par ces déplacements.

Après la mise en œuvre de l'étape 120, une étape 130 est réalisée et consiste à déterminer, à partir des mesures réalisées à l'étape 120, une fonction définissant un nombre de déplacements maximal au-delà duquel la résistance électrique de contact entre les contacts électriques 106, 110 dépasse une valeur maximale prédéfinie représentative d'un état dégradé de la connexion entre les contacts 106, 110, en fonction de l'amplitude de déplacement des contacts 106, 110 l'un contre l'autre. Un exemple de courbe représentative d'une telle fonction est représentée sur la figure 3, avec l'amplitude de déplacement représentée sur l'axe des ordonnées et le nombre de déplacements représenté sur l'axe des abscisses.

Une analyse modale expérimentale des connecteurs 100, 102 est ensuite mise en œuvre. L'objectif de l'analyse modale expérimentale est de déterminer les caractéristiques dynamiques des connecteurs 100, 102 et d'identifier les fonctions de transfert dynamique des boîtiers 104, 108 aux contacts électriques 106, 110, c'est-à-dire la réponse dynamique des connecteurs 100, 102 en fonction des sollicitations mécaniques subies.

Lors de cette analyse, des sollicitations mécaniques connues sont appliquées aux boîtiers 104, 108 des connecteurs 100, 102, et leur réponse transmise aux logements dans lesquels se trouvent les contacts électriques 106, 110 est mesurée. Pour cela, au cours d'une étape 140, les boîtiers 104, 108 sont soumis à des sollicitations mécaniques d'amplitude et de fréquence de valeurs différentes, et les amplitudes de déplacement, au niveau de chacun des logements des boîtiers 104, 108 dans lesquels les contacts électriques 106, 110 sont destinés à être disposés, sont mesurées.

Ensuite, au cours d'une étape 150, à partir des mesures d'amplitudes de déplacement des logements réalisées précédemment, des fonctions de transfert dynamique des boîtiers 104, 108 définissant l'amplitude de déplacement des contacts électriques 106, 110 en fonction de l'amplitude et de la fréquence de sollicitations mécaniques appliquées aux boîtiers 104, 108 sont déterminées.

Selon un exemple de réalisation, les amplitudes de déplacement des logements des boîtiers 104, 108 sont mesurées par des accéléromètres et/ou des capteurs de vibration. De plus, les sollicitations mécaniques auxquelles sont soumis les boîtiers 104, 108 sont par exemple appliquées par au moins un marteau d'impact dynamique doté d'une tête couplée à un capteur de force configuré pour mesurer l'amplitude et la fréquence des sollicitations mécaniques appliquées, ou en utilisant un pot vibrant. Ces différents éléments (accéléromètres et/ou capteurs de vibration, et le capteur de force ou le pot vibrant) peuvent être couplés électriquement à au moins un analyseur de spectre déterminant les fonctions de transfert dynamique des boîtiers 104, 108.

Une fois les fonctions de transfert dynamique des boîtiers 104, 108 déterminées, il est alors possible de calculer l'amplitude de débattement potentielle des contacts électriques 106, 110 installés dans les boîtiers 104, 108 qui correspond au résultat donné par les fonctions de transfert dynamique des boîtiers 104, 108 en appliquant les sollicitations vibratoires que peuvent subir les connecteurs 100, 102 en tant que données d'entrée. Ces sollicitations vibratoires sont par exemple données en fonction de conditions d'installation prévues pour les connecteurs 100, 102.

En effet, en sachant que pour une sollicitation donnée, les contacts électriques 106, 110 logés dans les boîtiers 104, 108 se déplaceront en mouvement relatif avec une certaine amplitude de déplacement, et en connaissant l'endurance des contacts électriques 106, 110 soumis à une telle amplitude de déplacement, il est possible de conclure sur la durée de vie de la connexion entre les contacts électriques 106, 110 en fonction de cette sollicitation, et donc en fonction par exemple d'une zone d'installation des connecteurs 100, 102 dans un véhicule (tel qu'un aéronef) pour laquelle les sollicitations subies dans celle-ci sont connues.

Ainsi, au cours d'une étape 160, pour des valeurs données d'amplitude et de fréquence de sollicitations mécaniques appliquées aux connecteurs 100, 102, la durée de vie de la connexion entre les connecteurs 100, 102 est déterminée. Cette durée de vie correspond au nombre de déplacements maximal au-delà duquel la résistance électrique de contact entre les contacts électriques 106, 110 dépasse la valeur maximale prédéfinie représentative d'un état dégradé de la connexion. Ce nombre de déplacements maximal est déterminé à partir de la fonction définissant le nombre de déplacements maximal au-delà duquel la résistance électrique de contact entre les contacts électriques 106, 110 dépasse la valeur maximale prédéfinie représentative d'un état dégradé de la connexion en fonction de l'amplitude de déplacement, pour une amplitude de déplacement des contacts électriques 106, 110 l'un contre l'autre dont la valeur est déterminée par les fonctions de transfert dynamique des connecteurs 100, 102 pour les valeurs données d'amplitude et de fréquence des sollicitations mécaniques appliquées aux connecteurs 100, 102.

De manière avantageuse, outre l'amplitude de déplacement des contacts électriques 106, 110, il est possible de prendre également en considération la fréquence du fretting entre les contacts électriques 106, 110. Pour cela, les étapes du procédé sont mises en œuvre telles que :
- à l'étape 120, l'évolution de la résistance électrique de contact entre les contacts électriques 106, 110 seuls peut être mesurée pour plusieurs valeurs de fréquence des déplacements subis par les contacts électriques 106, 110 seuls lors de ces mesures ;
- à l'étape 130, la fonction définissant le nombre de déplacements maximal au-delà duquel la résistance électrique de contact entre les contacts électriques 106, 110 dépasse une valeur maximale prédéfinie représentative d'un état dégradé de la connexion en fonction de l'amplitude de déplacement est déterminée pour ces différentes valeurs de fréquence des déplacements subis par les contacts électriques 106, 110 ;
- à l'étape 140, une fréquence de déplacement des logements des boîtiers 104, 108 est alors également mesurée lorsque les boîtiers 104, 108 sont soumis aux sollicitations mécaniques d'amplitude et de fréquence de valeurs différentes ;
- à l'étape 150, les fonctions de transfert dynamique des boîtiers 104, 108 sont ensuite déterminées telles qu'elles définissent également des valeurs de fréquence de déplacement des contacts électriques 106, 110 en fonction des valeurs d'amplitude et de fréquence des sollicitations mécaniques ;
- enfin, à l'étape 160, le nombre de déplacements maximal au-delà duquel la résistance électrique de contact entre les contacts électriques 106, 110 dépasse la valeur maximale prédéfinie représentative d'un état dégradé de la connexion est déterminé également pour une fréquence de déplacement des contacts électriques 106, 110 l'un contre l'autre dont la valeur est déterminée par les fonctions de transfert dynamique des boîtiers 104, 108 pour les valeurs données de l'amplitude et de la fréquence des sollicitations mécaniques.

Dans le procédé décrit ci-dessus, les étapes 120 à 150 sont mises en œuvre dans des conditions environnementales données. De manière avantageuse, il est possible de répéter ces étapes en modifiant à chaque fois ces conditions environnementales, c'est-à-dire en modifiant à chaque fois les valeurs de température et/ou d'humidité relative dans lesquelles se trouvent les connecteurs 100, 102. Dans ce cas :
- aux étapes 120 et 140, les mesures de l'évolution de la résistance électrique de contact entre les contacts électriques 106, 110 seuls et des amplitudes de déplacement des logements des boîtiers 104, 108 sont chacune réalisées dans les différentes conditions environnementales données ;
- aux étapes 130 et 150, la fonction définissant le nombre de déplacements maximal au-delà duquel la résistance électrique de contact entre les contacts électriques 106, 110 dépasse la valeur maximale prédéfinie représentative d'un état dégradé de la connexion en fonction de l'amplitude de déplacement et les fonctions de transfert dynamique des boîtiers 104, 108 sont déterminées pour chacune des différentes conditions environnementales ;
- à l'étape 160, la durée de vie de la connexion entre les connecteurs 100, 102 est déterminée à partir de la fonction définissant le nombre de déplacements maximal au-delà duquel la résistance électrique de contact entre les contacts électriques 106, 110 dépasse la valeur maximale prédéfinie représentative d'un état dégradé de la connexion en fonction de l'amplitude de déplacement et des fonctions de transfert dynamique des boîtiers 104, 108 obtenues dans des conditions environnementales données identiques.

Dans le procédé et les différentes variantes ci-dessus, la durée de vie de la connexion entre les connecteurs 100, 102 est évaluée en déterminant le nombre de cycles de fretting au-delà duquel la connexion électrique entre eux est dégradée. Lorsque les sollicitations mécaniques auxquelles les connecteurs 100, 102 sont soumis n'engendrent pas une amplitude de déplacement des contacts électriques 106, 110 qui soit supérieure à l'amplitude de transition de ces contacts, la durée de vie de la connexion électrique entre les connecteurs 100, 102 peut être considérée comme infinie. Le procédé décrit ci-dessus peut être mis en œuvre de manière à déterminer si la connexion électrique entre les connecteurs 100, 102, soumise à des sollicitation mécaniques données, a une telle durée de vie pouvant être considérée comme infinie. Pour cela :
- à partir des mesures de l'évolution de la résistance électrique de contact entre les contacts électriques 106, 110 seuls réalisées à l'étape 120, une valeur d'amplitude de déplacement des contacts électriques 106, 110 l'un contre l'autre pour laquelle la résistance électrique de contact entre les contacts électriques 106, 110 reste inférieure à une valeur prédéfinie représentative d'un début de dégradation de la connexion entre les contacts électriques 106, 110 est déterminée, et
- pour les valeurs données d'amplitude et de fréquence des sollicitations mécaniques appliquées aux connecteurs 100, 102, une absence ou non de dégradation de la connexion entre les connecteurs 100, 102 est déterminée en comparant la valeur d'amplitude de déplacement des contacts électriques 106, 110 l'un contre l'autre pour laquelle la résistance électrique de contact entre les contacts électriques 106, 110 reste inférieure à la valeur prédéfinie représentative d'un début de dégradation de la connexion avec la valeur d'amplitude de déplacement des contacts électriques 106, 110 l'un contre l'autre déterminée par les fonctions de transfert dynamique des boîtiers pour les valeurs données d'amplitude et de fréquence des sollicitations mécaniques appliquées aux connecteurs 100, 102.

Dans le procédé et les différentes variantes décrites ci-dessus, les étapes 120 et 130 peuvent être mises en œuvre avant ou après ou simultanément aux étapes 140 et 150.

## Revendications

1. Procédé d'évaluation de la durée de vie d'une connexion électrique entre au moins deux connecteurs (100, 102) comprenant chacun au moins un contact électrique (106, 110) logé dans un boîtier (104, 108), les boîtiers (104, 108) des deux connecteurs (100, 102) étant configurés pour être couplés mécaniquement l'un à l'autre, comprenant les étapes suivantes :
- mesure de l'évolution de la résistance électrique de contact entre les contacts électriques (106, 110) seuls, sans la présence d'autre élément des connecteurs (100, 102), en fonction d'un nombre de déplacements des contacts électriques (106, 110) l'un contre l'autre et pour plusieurs valeurs d'amplitude de déplacement des contacts électriques (106, 110) l'un contre l'autre ;
- détermination, à partir des mesures de l'évolution de la résistance électrique de contact entre les contacts électriques (106, 110), d'une fonction définissant un nombre de déplacements maximal au-delà duquel la résistance électrique de contact entre les contacts électriques (106, 110) dépasse une valeur maximale prédéfinie représentative d'un état dégradé de la connexion, en fonction de l'amplitude de déplacement ;
- mesure d'amplitudes de déplacement, au niveau de chacun des logements des boîtiers (104, 108) des connecteurs (100, 102) dans lesquels les contacts électriques (106, 110) sont destinés à être disposés, en soumettant les boîtiers (104, 108) à des sollicitations mécaniques d'amplitude et de fréquence de valeurs différentes ; **caractérisé en ce que** ledit procédé comprend les étapes suivantes :
- détermination, à partir des mesures d'amplitudes de déplacement, de fonctions de transfert dynamique des boîtiers (104, 108) définissant l'amplitude de déplacement des contacts électriques (106, 110) en fonction de l'amplitude et de la fréquence des sollicitations mécaniques appliquées aux boîtiers (104, 108) ;
- détermination, pour des valeurs données d'amplitude et de fréquence de sollicitations mécaniques appliquées aux connecteurs (100, 102), de la durée de vie de la connexion entre les connecteurs (100, 102) correspondant au nombre de déplacements maximal au-delà duquel la résistance électrique de contact entre les contacts électriques (106, 110) dépasse la valeur maximale prédéfinie représentative d'un état dégradé de la connexion, ce nombre de déplacements maximal étant déterminé à partir de la fonction définissant le nombre de déplacements maximal au-delà duquel la résistance électrique de contact entre les contacts électriques (106, 110) dépasse la valeur maximale prédéfinie représentative d'un état dégradé de la connexion en fonction de l'amplitude de déplacement, pour une amplitude de déplacement des contacts électriques (106, 110) l'un contre l'autre dont la valeur est déterminée par les fonctions de transfert dynamique des connecteurs (100, 102) pour les valeurs données d'amplitude et de fréquence des sollicitations mécaniques appliquées aux connecteurs (100, 102).

2. Procédé selon la revendication 1, dans lequel :
- l'évolution de la résistance électrique de contact entre les contacts électriques (106, 110) seuls est mesurée pour plusieurs valeurs de fréquence des déplacements subis par les contacts électriques (106, 110) lors de ces mesures, et la fonction définissant le nombre de déplacements maximal au-delà duquel la résistance électrique de contact entre les contacts électriques (106, 110) dépasse la valeur maximale prédéfinie représentative d'un état dégradé de la connexion en fonction de l'amplitude de déplacement est déterminée pour ces différentes valeurs de fréquence des déplacements subis par les contacts électriques (106, 110), et
- une fréquence de déplacement des logements des boîtiers (104, 108) est également mesurée lorsque les boîtiers (104, 108) sont soumis aux sollicitations mécaniques d'amplitude et de fréquence de valeurs différentes, et les fonctions de transfert dynamique des boîtiers (104, 108) sont déterminées telles qu'elles définissent également des valeurs de fréquence de déplacement des contacts électriques (106, 110) en fonction des valeurs d'amplitude et de fréquence des sollicitations mécaniques, et
- le nombre de déplacements maximal au-delà duquel la résistance électrique de contact entre les contacts électriques (106, 110) dépasse la valeur maximale prédéfinie représentative d'un état dégradé de la connexion est déterminé également pour une fréquence de déplacement des contacts électriques (106, 110) l'un contre l'autre dont la valeur est déterminée par les fonctions de transfert dynamique des boîtiers (104, 108) pour les valeurs données de l'amplitude et de la fréquence des sollicitations mécaniques.

3. Procédé selon l'une des revendications précédentes, dans lequel :
- les mesures de l'évolution de la résistance électrique de contact entre les contacts électriques (106, 110) seuls et des amplitudes de déplacement des logements des boîtiers (104, 108) sont chacune réalisées dans différentes conditions environnementales données pour lesquelles les valeurs de température et/ou d'humidité relative et/ou de pression diffèrent les unes des autres, et
- la fonction définissant le nombre de déplacements maximal au-delà duquel la résistance électrique de contact entre les contacts électriques (106, 110) dépasse la valeur maximale prédéfinie représentative d'un état dégradé de la connexion en fonction de l'amplitude de déplacement et les fonctions de transfert dynamique des boîtiers (104, 108) sont déterminées pour chacune des différentes conditions environnementales, et
- la durée de vie de la connexion entre les connecteurs (100, 102) est déterminée à partir de la fonction définissant le nombre de déplacements maximal au-delà duquel la résistance électrique de contact entre les contacts électriques (106, 110) dépasse la valeur maximale prédéfinie représentative d'un état dégradé de la connexion en fonction de l'amplitude de déplacement et des fonctions de transfert dynamique des boîtiers (104, 108) obtenues dans des conditions environnementales données identiques.

4. Procédé selon l'une des revendications précédentes, comportant en outre :
- à partir des mesures de l'évolution de la résistance électrique de contact entre les contacts électriques (106, 110) seuls, détermination d'une valeur d'amplitude de déplacement des contacts électriques (106, 110) l'un contre l'autre pour laquelle la résistance électrique de contact entre les contacts électriques (106, 110) reste inférieure à une valeur prédéfinie représentative d'un début de dégradation de la connexion, et
- détermination, pour les valeurs données d'amplitude et de fréquence des sollicitations mécaniques appliquées aux connecteurs (100, 102), d'une absence ou non de dégradation de la connexion entre les connecteurs (100, 102) en comparant la valeur d'amplitude de déplacement des contacts électriques (106, 110) l'un contre l'autre pour laquelle la résistance électrique de contact entre les contacts électriques (106, 110) reste inférieure à la valeur prédéfinie représentative d'un début de dégradation de la connexion avec la valeur d'amplitude de déplacement des contacts électriques (106, 110) l'un contre l'autre déterminée par les fonctions de transfert dynamique des boîtiers (104, 108) pour les valeurs données d'amplitude et de fréquence des sollicitations mécaniques appliquées aux connecteurs (100, 102).

5. Procédé selon l'une des revendications précédentes, dans lequel :
- les amplitudes de déplacement des logements des boîtiers (104, 108) sont mesurées par des accéléromètres et/ou des capteurs de vibration, et
- les sollicitations mécaniques auxquelles sont soumis les boîtiers (104, 108) sont appliquées par au moins un marteau d'impact doté d'une tête couplée à un capteur de force configuré pour mesurer l'amplitude et la fréquence des sollicitations mécaniques appliquées, ou par un pot vibrant, et
- les accéléromètres et/ou les capteurs de vibration, et le capteur de force ou le pot vibrant, sont couplés électriquement à au moins un analyseur de spectre déterminant les fonctions de transfert dynamique des boîtiers (104, 108).

6. Procédé selon l'une des revendications précédentes, dans lequel l'un des contacts électriques (106) correspond à un contact électrique mâle, et l'autre des contacts électriques (110) correspond à un contact électrique femelle.

7. Procédé selon l'une des revendications précédentes, dans lequel les valeurs différentes d'amplitude et de fréquence des sollicitations mécaniques sont représentatives de différents emplacements dans un véhicule de transport.

8. Procédé selon la revendication 7, dans lequel le véhicule de transport est un aéronef.

## Patentansprüche

1. Verfahren zur Bewertung der Lebensdauer einer elektrischen Verbindung zwischen mindestens zwei Verbindern (100, 102), die jeweils mindestens einen elektrischen Kontakt (106, 110) umfassen, der in einem Gehäuse (104, 108) untergebracht ist, wobei die Gehäuse (104, 108) der beiden Verbinder (100, 102) so ausgebildet sind, dass sie mechanisch miteinander gekoppelt sind, umfassend die folgenden Schritte:
- Messen der Entwicklung des elektrischen Kontaktwiderstands zwischen den elektrischen Kontakten (106, 110) allein, ohne das Vorhandensein eines anderen Elements der Verbinder (100, 102), in Abhängigkeit von einer Anzahl von Verschiebungen der elektrischen Kontakte (106, 110) gegeneinander und für mehrere Verschiebungsamplitudenwerte der elektrischen Kontakte (106, 110) gegeneinander;
- Bestimmen, ausgehend von den Messungen der Entwicklung des elektrischen Kontaktwiderstands zwischen den elektrischen Kontakten (106, 110), einer Funktion, die eine maximale Anzahl von Verschiebungen definiert, oberhalb derer der elektrische Kontaktwiderstand zwischen den elektrischen Kontakten (106, 110) einen vorgegebenen maximalen Wert überschreitet, der für einen verschlechterten Zustand der Verbindung repräsentativ ist, in Abhängigkeit von der Verschiebungsamplitude;
- Messen von Verschiebungsamplituden an jeder der Aufnahmen der Gehäuse (104, 108) der Verbinder (100, 102), in denen die elektrischen Kontakte (106, 110) angeordnet sein sollen, indem die Gehäuse (104, 108) mechanischen Beanspruchungen mit unterschiedlichen Amplituden- und Frequenzwerten ausgesetzt werden; **dadurch gekennzeichnet, dass** das Verfahren die folgenden Schritte umfasst:
- Bestimmen, ausgehend von den Messungen der Verschiebungsamplituden, von dynamischen Übertragungsfunktionen der Gehäuse (104, 108), die die Verschiebungsamplitude der elektrischen Kontakte (106, 110) in Abhängigkeit von der Amplitude und der Frequenz der an die Gehäuse (104, 108) angelegten mechanischen Beanspruchungen definieren;
- Bestimmen, für gegebene Amplituden- und Frequenzwerte der an den Verbindern (100, 102) angelegten mechanischen Beanspruchungen, der Lebensdauer der Verbindung zwischen den Verbindern (100, 102), die der maximalen Anzahl von Verschiebungen entspricht, oberhalb derer der elektrische Kontaktwiderstand zwischen den elektrischen Kontakten (106, 110) den vorgegebenen maximalen Wert überschreitet, der für einen verschlechterten Zustand der Verbindung repräsentativ ist, wobei diese maximale Anzahl von Verschiebungen ausgehend von der Funktion bestimmt wird, die die maximale Anzahl von Verschiebungen definiert, oberhalb derer der elektrische Kontaktwiderstand zwischen den elektrischen Kontakten (106, 110) den vorgegebenen maximalen Wert überschreitet, der für einen verschlechterten Zustand der Verbindung in Abhängigkeit von der Verschiebungsamplitude repräsentativ ist, für eine Verschiebungsamplitude der elektrischen Kontakte (106, 110) gegeneinander, deren Wert durch die dynamischen Übertragungsfunktionen der Verbinder (100, 102) für die gegebenen Amplituden- und Frequenzwerte der an die Verbinder (100, 102) angelegten mechanischen Beanspruchungen bestimmt wird.

2. Verfahren nach Anspruch 1, wobei:
- die Entwicklung des elektrischen Kontaktwiderstands zwischen den elektrischen Kontakten (106, 110) allein für mehrere Frequenzwerte der Verschiebungen gemessen, die die elektrischen Kontakte (106, 110) bei diesen Messungen erleiden, und die Funktion, die die maximale Anzahl der Verschiebungen definiert, oberhalb derer der elektrische Kontaktwiderstand zwischen den elektrischen Kontakten (106, 110) den vorgegebenen Maximalwert überschreitet, der für einen verschlechterten Zustand der Verbindung in Abhängigkeit von der Verschiebungsamplitude repräsentativ ist, für diese unterschiedlichen Frequenzwerte der von den elektrischen Kontakten (106, 110) erlittenen Verschiebungen bestimmt wird, und
- eine Verschiebefrequenz der Aufnahmen der Gehäuse (104, 108) auch gemessen wird, wenn die Gehäuse (104, 108) mechanischen Beanspruchungen mit unterschiedlichen Amplituden- und Frequenzwerten ausgesetzt sind, und die dynamischen Übertragungsfunktionen der Gehäuse (104, 108) so bestimmt werden, dass sie auch Verschiebefrequenzwerte der elektrischen Kontakte (106, 110) in Abhängigkeit von den Amplituden- und Frequenzwerten der mechanischen Beanspruchungen definieren, und
- die maximale Anzahl der Verschiebungen, oberhalb derer der elektrische Kontaktwiderstand zwischen den elektrischen Kontakten (106, 110) den vorgegebenen maximalen Wert überschreitet, der für einen verschlechterten Zustand der Verbindung repräsentativ ist, auch für eine Verschiebefrequenz der elektrischen Kontakte (106, 110) gegeneinander bestimmt wird, deren Wert durch die dynamischen Übertragungsfunktionen der Gehäuse (104, 108) für die gegebenen Amplituden- und Frequenzwerte der mechanischen Beanspruchungen bestimmt wird.

3. Verfahren nach einem der vorhergehenden Ansprüche, wobei:
- die Messungen der Entwicklung des elektrischen Kontaktwiderstands zwischen den elektrischen Kontakten (106, 110) allein und der Verschiebungsamplituden der Aufnahmen der Gehäuse (104, 108) jeweils unter unterschiedlichen gegebenen Umgebungsbedingungen durchgeführt werden, für die die Werte für Temperatur und/oder relative Luftfeuchtigkeit und/oder Druck voneinander abweichen, und
- die Funktion, die die maximale Anzahl von Verschiebungen definiert, oberhalb derer der elektrische Kontaktwiderstand zwischen den elektrischen Kontakten (106, 110) den vorgegebenen maximalen Wert überschreitet, der für einen verschlechterten Zustand der Verbindung in Abhängigkeit von der Verschiebungsamplitude repräsentativ ist, und die dynamischen Übertragungsfunktionen der Gehäuse (104, 108) für jede der unterschiedlichen Umgebungsbedingungen bestimmt werden, und
- die Lebensdauer der Verbindung zwischen den Verbindern (100, 102) ausgehend von der Funktion bestimmt wird, die die maximale Anzahl der Verschiebungen definiert, oberhalb derer der elektrische Kontaktwiderstand zwischen den elektrischen Kontakten (106, 110) den vorgegebenen maximalen Wert überschreitet, der für einen verschlechterten Zustand der Verbindung in Abhängigkeit von der Verschiebungsamplitude und den dynamischen Übertragungsfunktionen der Gehäuse (104, 108) repräsentativ ist, die unter identischen gegebenen Umgebungsbedingungen erhalten wurden.

4. Verfahren nach einem der vorhergehenden Ansprüche, das ferner aufweist:
- Bestimmen, ausgehend von den Messungen der Entwicklung des elektrischen Kontaktwiderstands zwischen den elektrischen Kontakten (106, 110) allein, eines Verschiebungsamplitudenwertes der elektrischen Kontakte (106, 110) gegeneinander, für den der elektrische Kontaktwiderstand zwischen den elektrischen Kontakten (106, 110) unter einem vorgegebenen Wert bleibt, der für einen Beginn der Verschlechterung der Verbindung repräsentativ ist, und
- Bestimmen, für die gegebenen Amplituden- und Frequenzwerte der an die Verbinder (100, 102) angelegten mechanischen Beanspruchungen, einer Abwesenheit oder nicht der Verschlechterung der Verbindung zwischen den Verbindern (100, 102) durch Vergleichen des Verschiebungsamplitudenwertes der elektrischen Kontakte (106, 110) gegeneinander, für den der elektrische Kontaktwiderstand zwischen den elektrischen Kontakten (106, 110) unter dem vorgegebenen Wert bleibt, der für einen Beginn der Verschlechterung der Verbindung repräsentativ ist, mit dem Verschiebungsamplitudenwert der elektrischen Kontakte (106, 110) gegeneinander, der von den dynamischen Übertragungsfunktionen der Gehäuse (104, 108) für die gegebenen Amplitudenund Frequenzwerte der an den Verbindern (100, 102) anliegenden mechanischen Beanspruchungen bestimmt wurde.

5. Verfahren nach einem der vorhergehenden Ansprüche, wobei:
- die Verschiebungsamplituden der Aufnahmen der Gehäuse (104, 108) durch Beschleunigungsmesser und/oder Schwingungssensoren gemessen werden, und
- die mechanischen Beanspruchungen, denen die Gehäuse (104, 108) ausgesetzt sind, von mindestens einem Schlaghammer mit einem Kopf, der mit einem Kraftsensor gekoppelt ist, der so kausgebildet ist, dass er die Amplitude und Frequenz der angewendeten mechanischen Beanspruchungen misst, oder von einem Schwingtopf aufgebracht werden, und
- die Beschleunigungsmesser und/oder die Schwingungssensoren und der Kraftsensor oder der Schwingtopf elektrisch mit mindestens einem Spektrumanalysator gekoppelt sind, der die dynamischen Übertragungsfunktionen der Gehäuse (104, 108) bestimmt.

6. Verfahren nach einem der vorhergehenden Ansprüche, wobei einer der elektrischen Kontakte (106) einem männlichen elektrischen Kontakt und der andere der elektrischen Kontakte (110) einem weiblichen elektrischen Kontakt entspricht.

7. Verfahren nach einem der vorhergehenden Ansprüche, wobei die unterschiedlichen Amplituden- und Frequenzwerte der mechanischen Beanspruchungen für unterschiedliche Stellen in einem Transportfahrzeug repräsentativ sind.

8. Verfahren nach Anspruch 7, wobei das Transportfahrzeug ein Luftfahrzeug ist.

## Claims

1. Method for evaluating the service life of an electrical connection between at least two connectors (100, 102) each comprising at least one electrical contact (106, 110) housed in a housing (104, 108), the housings (104, 108) of the two connectors (100, 102) being configured to be mechanically coupled to each other, comprising the following steps:
- measuring the evolution of the electrical contact resistance between the electrical contacts (106, 110) alone, without the presence of another element of the connectors (100, 102), as a function of a number of displacements of the electrical contacts (106, 110) against each other and for several displacement amplitude values of the electrical contacts (106, 110) against each other;
- determining, from the measurements of the evolution of the electrical contact resistance between the electrical contacts (106, 110), a function defining a maximum number of displacements beyond which the electrical contact resistance between the electrical contacts (106, 110) exceeds a predefined maximum value representative of a degraded state of the connection, as a function of the displacement amplitude;
- measuring displacement amplitudes, at each of the receptacles of the housings (104, 108) of the connectors (100, 102) in which the electrical contacts (106, 110) are intended to be arranged, by subjecting the housings (104, 108) to mechanical stresses with amplitudes and frequencies of different values; **characterised in that** said method comprises the following steps:
- determining, from the measurements of displacement amplitudes, dynamic transfer functions of the housings (104, 108) defining the displacement amplitude of the electrical contacts (106, 110) as a function of the amplitude and frequency of the mechanical stresses applied to the housings (104, 108);
- determining, for given values of amplitude and frequency of mechanical stresses applied to the connectors (100, 102), the service life of the connection between the connectors (100, 102) corresponding to the maximum number of displacements beyond which the electrical contact resistance between the electrical contacts (106, 110) exceeds the predefined maximum value representative of a degraded state of the connection, this maximum number of displacements being determined from the function defining the maximum number of displacements beyond which the electrical contact resistance between the electrical contacts (106, 110) exceeds the predefined maximum value representative of a degraded state of the connection as a function of the displacement amplitude, for a displacement amplitude of the electrical contacts (106, 110) against each other whose value is determined by the dynamic transfer functions of the connectors (100, 102) for the given values of amplitude and frequency of the mechanical stresses applied to the connectors (100, 102).

2. Method according to claim 1, wherein
- the evolution of the electrical contact resistance between the electrical contacts (106, 110) alone is measured for several frequency values of the displacements undergone by the electrical contacts (106, 110) during these measurements, and the function defining the maximum number of displacements beyond which the electrical contact resistance between the electrical contacts (106, 110) exceeds the predefined maximum value representative of a degraded state of the connection as a function of the displacement amplitude is determined for these different frequency values of the displacements undergone by the electrical contacts (106, 110), and
- a frequency of displacement of the receptacles of the housings (104, 108) is also measured when the housings (104, 108) are subjected to the mechanical stresses with amplitudes and frequencies of different values, and the dynamic transfer functions of the housings (104, 108) are determined such that they also define values of frequency of displacement of the electrical contacts (106, 110) as a function of the amplitude and frequency values of the mechanical stresses, and
- the maximum number of displacements beyond which the electrical contact resistance between the electrical contacts (106, 110) exceeds the predefined maximum value representative of a degraded state of the connection is also determined for a frequency of displacement of the electrical contacts (106, 110) against each other whose value is determined by the dynamic transfer functions of the housings (104, 108) for the given values of the amplitude and frequency of the mechanical stresses.

3. Method according to one of the preceding claims, wherein:
- the measurements of the evolution of the electrical contact resistance between the electrical contacts (106, 110) alone and the amplitudes of displacement of the receptacles of the housings (104, 108) are each carried out under different given environmental conditions for which the temperature and/or relative humidity and/or pressure values differ from each other, and
- the function defining the maximum number of displacements beyond which the electrical contact resistance between the electrical contacts (106, 110) exceeds the predefined maximum value representative of a degraded state of the connection according to the amplitude of displacement and the dynamic transfer functions of the housings (104, 108) are determined for each of the different environmental conditions, and
- the service life of the connection between the connectors (100, 102) is determined from the function defining the maximum number of displacements beyond which the electrical contact resistance between the electrical contacts (106, 110) exceeds the predefined maximum value representative of a degraded state of the connection according to the amplitude of displacement and the dynamic transfer functions of the housings (104, 108) obtained under identical given environmental conditions.

4. Method according to one of the preceding claims, further comprising:
- from the measurements of the evolution of the electrical contact resistance between the electrical contacts (106, 110) alone, determining a value of an amplitude of displacement of the electrical contacts (106, 110) against each other for which the electrical contact resistance between the electrical contacts (106, 110) remains less than a predefined value representative of a start of degradation of the connection, and
- determining, for the given values of amplitude and frequency of the mechanical stresses applied to the connectors (100, 102), whether or not there is a degradation of the connection between the connectors (100, 102) by comparing the displacement amplitude value of the electrical contacts (106, 110) against each other for which the electrical contact resistance between the electrical contacts (106, 110) remains less than the predefined value representative of a start of degradation of the connection with the displacement amplitude value of the electrical contacts (106, 110) against each other determined by the dynamic transfer functions of the housings (104, 108) for the given values of amplitude and frequency of the mechanical stresses applied to the connectors (100, 102).

5. Method according to one of the preceding claims, wherein:
- the amplitudes of displacement of the receptacles of the housings (104, 108) are measured by accelerometers and/or vibration sensors, and
- the mechanical stresses to which the housings (104, 108) are subjected are applied by at least one impact hammer having a head coupled to a force sensor configured to measure the amplitude and frequency of the applied mechanical stresses, or by a vibrating pot, and
- the accelerometers and/or vibration sensors, and the force sensor or the vibrating pot, are electrically coupled to at least one spectrum analyzer determining the dynamic transfer functions of the housings (104, 108).

6. Method according to one of the preceding claims, wherein one of the electrical contacts (106) corresponds to a male electrical contact, and the other one of the electrical contacts (110) corresponds to a female electrical contact.

7. Method according to one of the preceding claims, wherein the different values of amplitude and frequency of the mechanical stresses are representative of different locations in a transport vehicle.

8. Method according to claim 7, wherein the transport vehicle is an aircraft.
